Europäisches Patentamt

European Patent Office

Office européen des brevets

(19)

(11)  EP 0 607 176 B1

(12)  FASCICULE DE BREVET EUROPEEN

(45) Date de publication et mention
de la délivrance du brevet:
**28.02.1996  Bulletin 1996/09**

(21) Numéro de dépôt: **92919437.1**

(22) Date de dépôt: **04.09.1992**

(51) Int Cl.⁶: **H03D 3/00**

(86) Numéro de dépôt international:
**PCT/FR92/00843**

(87) Numéro de publication internationale:
**WO 93/07676 (15.04.1993 Gazette 1993/10)**

(54) **PROCEDE DE DEMODULATION NUMERIQUE D'UN SIGNAL COMPOSITE**

VERFAHREN ZUR DIGITALEN DEMODULATION EINES ZUSAMMENGESETZTEN SIGNALS

METHOD FOR DIGITALLY DEMODULATING A COMPOSITE SIGNAL

(84) Etats contractants désignés:
**DE ES GB**

(30) Priorité: **08.10.1991 FR 9112350**

(43) Date de publication de la demande:
**27.07.1994  Bulletin 1994/30**

(73) Titulaire: **THOMSON-CSF**
**F-75008 Paris (FR)**

(72) Inventeurs:
• **RICCARDI, Guy**
  **F-92045 Paris-La Défense Cédex 67 (FR)**
• **CALVANO, Philippe**
  **F-92045 Paris-La Défense Cédex 67 (FR)**
• **NICOLAS, Jean-Luc**
  **F-92045 Paris-La Défense Cédex 67 (FR)**

(74) Mandataire: **Desperrier, Jean-Louis**
  **F-92402 Courbevoie Cédex (FR)**

(56) Documents cités:
DE-A- 3 938 671          US-A- 4 356 562
US-A- 4 879 694

## Description

La présente invention se rapporte aux dispositifs qui permettent de démoduler avec un traitement numérique un signal porteur d'une modulation composite. Elle concerne plus particulièrement les signaux transmis par radio depuis un véhicule marin transportant plusieurs signaux de mesure sous la forme d'un ensemble de modulations convenablement multiplexées entre elles.

On utilise couramment pour repérer divers objets situés dans le sein de la mer des bouées larguées d'un hélicoptère et qui procèdent à des sondages sonars. Les résultats de ces sondages sont transmis par un poste de radio VHF porté par la bouée vers un récepteur situé dans l'hélicoptère largueur, ou éventuellement dans un autre véhicule aérien ou marin.

Les informations ainsi transmises comprennent essentiellement des signaux de détection omnidirectionnels et directionnels et des indications d'orientation de la bouée permettant de donner une référence aux signaux directionnels. Ces signaux modulent la porteuse HF du poste radio de transmission selon un plan de modulation défini et connu. A la réception la démodulation du signal radio restitue les signaux de mesure, qui permettent de connaître l'emplacement des objets à repérer.

La technique universellement utilisée jusqu'à présent est de démoduler ce signal par des moyens analogiques classiques, comportant par exemple des filtres, des multiplicateurs etc.

On a proposé dans le brevet US 4 356 562 une méthode de démodulation numérique de ces signaux. Toutefois le système proposé utilise une fréquence d'échantillonnage variable asservie sur les fluctuations de la fréquence porteuse, ce qui complique très sérieusement le traitement numérique des signaux ainsi échantillonnés.

Pour pallier ces inconvénients l'invention propose un procédé de démodulation numérique d'un signal composite comprenant un premier signal omnidirectionnel en bande de base, une première sous-porteuse à une première fréquence Fp, une deuxième sous-porteuse à une fréquence 2Fp exactement égale au double de la fréquence Fp, un premier signal dipôlaire modulant en double bande latérale avec suppression de porteuse la deuxième sous-porteuse et un deuxième signal dipôlaire modulant en double bande latérale avec suppression de porteuse en quadrature avec le premier signal la deuxième sous-porteuse, principalement caractérisé en ce qu'on effectue les étapes suivantes :

- filtrage passe-bas pour isoler le signal omnidirectionnel ;
- démodulation complexe par une fréquence F0 très stable peu différente de Fp pour obtenir un premier signal de différence de fréquence entre F0 et Fp;
- élévation complexe au carré puis normalisation du signal conjugué de ce premier signal d'erreur pour obtenir un premier signal de correction de fréquence;
- démodulation complexe autour d'une deuxième fréquence à la fréquence 2F0 exactement égale à deux fois la fréquence F0 pour obtenir une première approximation des deux signaux dipôlaires ;
- multiplication complexe de cette première approximation de signaux dipôlaires par le premier signal de correction de fréquence pour obtenir des signaux dipolaires corrigés en fréquence ;
- filtrage passe-bas à très faible bande de ces signaux dipôlaires corrigés en fréquence pour isoler la composante continue correspondant à la deuxième sous-porteuse ramenée à la fréquence 0 ;
- élaboration d'un signal de correction de phase à partir de cette composante à la fréquence 0 ;
- multiplication complexe des signaux dipôlaires corrigés en fréquence par ce signal d'erreur de phase pour obtenir les signaux dipôlaires corrigés en fréquence et en phase.

D'autres particularités et avantages de l'invention apparaîtront clairement dans la description suivante faite à titre d'exemple non limitatif en regard des figures annexées qui représentent :

- la figure 1, le plan de fréquence du signal à démoduler ; et
- la figure 2, le diagramme d'un dispositif de démodulation selon l'invention.

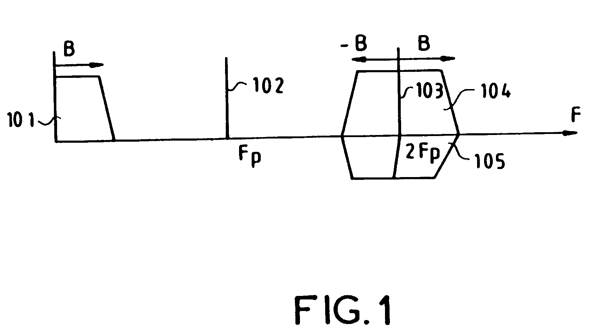

Le signal de modulation composite de la porteuse HF représenté sur la figure 1 correspond à un ensemble de signaux et de modulations généralement utilisés dans les bouées sonars. Il comprend :

- Un premier signal en bande 1021 de base qui permet de transmettre les signaux de réception omnidirectionnels du sonar. Ces signaux sont dits "signal omni". La largeur de bande de ce signal est par exemple de 2400 Hz.
- Une première sous-porteuse pure 102 de fréquence Fp égale par exemple à 7,5 kHz sert de référence. Compte tenu des moyens rudimentaires disponibles dans la bouée permettant de générer cette fréquence, celle-ci varie de manière aléatoire, par exemple de ±25 Hz. C'est cette variation qui pose les problèmes principaux du traitement ultérieur.
- Une deuxième sous-fréquence pure 103 à la fréquence 2Fp exactement égale au double de celle de la première sous-porteuse. Pour cela on génère simplement la deuxième sous-porteuse par doublement de fréquence de la première, ce qui permet d'obtenir une identité parfaite entre les fréquences. Bien sûr cette deuxième fréquence varie en suivant les variations de la première, dans des limites doubles bien entendu, c'est-à-dire par exemple ±50 hertz. Il faut noter que ce système ne garantit pas un écart de phase constant entre les deux sous-porteuses, et que justement cet écart de phase varie de manière aléatoire.

- Un premier signal dit "voie cosinus" correspondant aux signaux sonars reçus dans une première direction privilégiée, est-ouest en principe si la bouée est bien orientée, module la deuxième sous-porteuse en double-bande latérale avec suppression de porteuse (la sous-porteuse 102 est rajoutée après) et un déphasage obtenu à partir des indications d'un organe, un compas par exemple, qui mesure l'orientation (ou cap) de la bouée + dans l'exemple décrit 90°. Cette dernière indication est destinée dans le traitement ultérieur à bien orienter les signaux directionnels obtenus à partir du sonar. On obtient ainsi le signal de modulation 104.

- Un autre signal dit "voie sinus" correspondant aux signaux sonars reçus dans une autre voie privilégiée située à 90° de la précédente, donc nord-sud en principe, module la sous-porteuse de la même manière que le précédent mais en quadrature par rapport à cette modulation. On obtient ainsi le signal de modulation 105.

En fait en présence d'une source de bruit (ou d'un écho) unique, les signaux nord/sud et est/ouest sont les mêmes mais multipliés par $\sin\theta$ pour l'un et $\cos\theta$ pour l'autre, $\theta$ étant l'orientation de la source par rapport aux dipoles croisés qui forment les voies privilégiées de réception. Pour cette raison ces signaux sont appelés "signaux dipolaires".

Dans le récepteur situé par exemple dans l'hélicoptère largueur, le signal VHF est démodulé de manière connue, ce qui à ce niveau ne pose pas de problème de stabilité particulière. On obtient donc le signal de modulation composite représenté sur la figure 1. L'invention permet de démoduler et de démultiplexer ce signal de manière précise en utilisant un traitement numérique pour obtenir les signaux donnant les indications de réception du sonar, omnidirectionnels, est-ouest et nord-sud, ainsi que l'orientation des organes de réception directionnels du sonar nord-nord.

Le signal e(t) obtenu après démodulation du signal VHF et dont le spectre est représenté sur la figure 1, peut s'écrire avec la formule et les notations suivantes :

$s(t)$ : signal omni  
$Fp$ : valeur de la fréquence du signal de référence de fré quence  
$A_{FP}$ : amplitude du signal référence de fréquence  
$A_{2FP}$ : amplitude du signal référence de phase  
$\varnothing_{FP}$ : déphasage entre les deux signaux de référence (variable aléatoire)  
$\theta$ : gisement de la source  
$K$ : cap (angle entre le nord magnétique et l'axe de la bouée)  
$A_D$ : amplitude des signaux dipôlaires  
$A_Z =$ $\theta + K$: azimut de la source

$$e(t) = s(t)$$

$$+ A_{Fp}.\cos(2\P Fpt-\varnothing Fp)$$

$$+ A_{2Fp}.\cos(4\P Fpt)$$

$$+ A_D s(t)\cos(4\P Fpt+\frac{\P}{2} +A_z) \qquad (1)$$

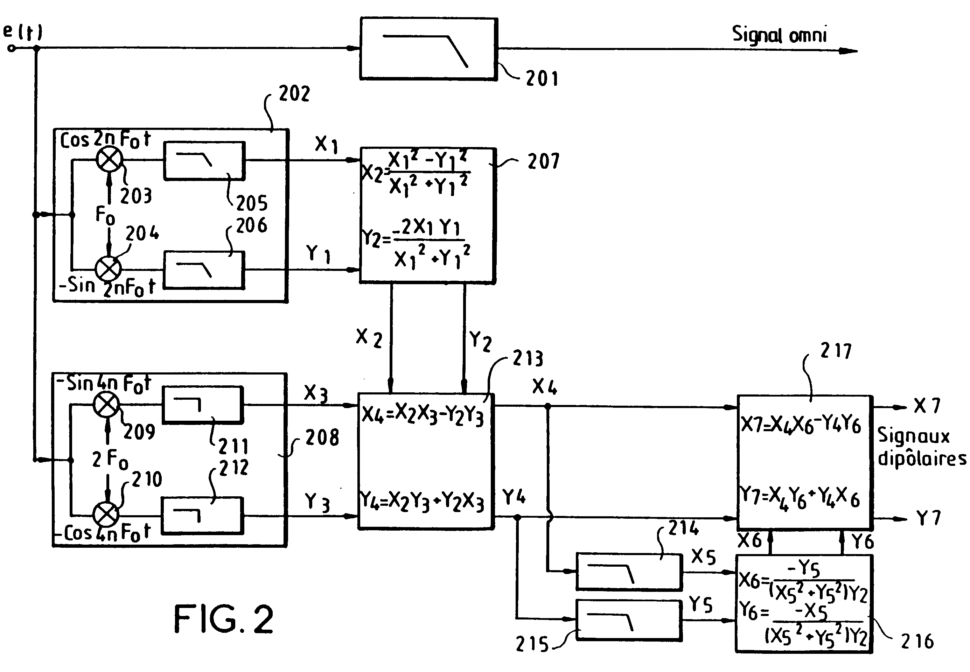

Ce signal e(t) est appliqué en entrée d'un dispositif numérique de démodulation permettant de mettre en oeuvre le procédé selon l'invention dont le schéma bloc de principe est représenté sur la figure 2.

Pour obtenir le signal omni, on filtre tout simplement le signal e(t) par un filtre passe-bas 201 dont la fréquence de coupure permet de rejeter les fréquences hautes au moins à partir de Fp tout en laissant passer avec un minimum de déformation le signal omni représenté en 101 sur la figure 1. Cette fréquence est dans l'exemple numérique décrit de par exemple 2,56 kHz.

Pour démoduler de manière complexe les signaux 104 et 105 afin de ramener les signaux dipôlaires en bande de base, il est nécessaire de partir d'une fréquence identique à la porteuse 103. Il n'est pas possible d'isoler directement cette porteuse par un filtrage étroit centré sur 2Fp, car les variations de cette fréquence sont plus grandes que la largeur du filtre nécessaire. En effet les signaux dipôlaires modulés en bandes latérales 104 et 105 comportent des fréquences qui sont très proches de 2Fp.

L'invention tire partie du fait que cette porteuse 103 à 2Fp est obtenue par doublement de la fréquence de la porteuse 102 à Fp, qui elle est isolée en dehors des bandes de modulation par les signaux provenant du sonar. En partant de cette constatation on mesure l'écart δF de la première sous-porteuse 102 par rapport à une fréquence fixe et très stable

F0, soit $\delta F = Fp-F0$, et cet écart sert à corriger la démodulation des signaux modulés 104 et 105 par rapport à une autre fréquence stable 2F0 obtenue par doublement de la première. La valeur de F0 sera choisie de préférence proche de la valeur moyenne théorique de Fp.

On procède donc à une démodulation complexe de e(t) à l'aide de la fréquence F0 dans un démodulateur 202. Pour cela on multiplie de manière classique e(t) par les des composantes en quadrature de F0 dans des multiplicateurs 203 et 204. Les produits de modulation sont ensuite filtrés dans deux filtres passe-bas 205 et 206 identiques au filtre 201 qui délivrent les deux composantes en quadrature de l'écart de fréquence $\delta F$, soit $X_1$ et $Y_1$. Ces filtres sont du type FIR à phase linéaire. De manière générale l'ensemble des filtres utilisés dans le traitement des signaux dans ce dispositif, sont de ce type FIR. La fréquence de coupure des filtres 205 et 206 est telle qu'elle permet d'encadrer les variations de la fréquence Fp en tenant compte éventuellement d'un écart constant entre F0 et la valeur moyenne de Fp si celles-ci ne sont pas identiques. Dans l'exemple numérique décrit plus haut, où Fp peut varier de 25 Hz et où F0 vaut 7489,8 Hz on prendra par exemple des filtres avec une fréquence de coupure de 36 Hz.

Pour obtenir alors le terme correcteur à utiliser ultérieurement, on procède alors à un doublement en fréquence du signal d'erreur ainsi obtenu dans un multiplicateur 207 où on élève au carré le signal conjugué du signal d'erreur délivré par le démodulateur 202 en le normalisant en amplitude au carré. Cette opération permet d'obtenir les composantes du signal complexe de correction de fréquence $X_2$ et $Y_2$ données par les formules :

$$X_2 = ( X_1^{\,2} - Y_1^{\,2} )/(X_1^{\,2} + Y_1^{\,2}) \qquad (2)$$

$$Y_2 = -2X_1 Y_1/(X_1^{\,2} + Y_1^{\,2}) \qquad (3)$$

On obtient tout d'abord une première approximation des signaux dipôlaires en procédant à une démodulation complexe de e(t) par un signal à fréquence 2F0 obtenu directement par doublement du signal à F0 utilisé dans le démodulateur 202. Cette opération s'effectue dans un démodulateur complexe 208, qui utilise de la même manière que le démodulateur 202 deux multiplicateurs 209 et 210 suivis de deux filtres passe-bas identique 211 et 212 dont la bande passante est prévue pour laisser passer les composantes des signaux dipôlaires, compte tenu de l'écart de fréquence maximum entre 2F0 et 2Fp. Dans l'exemple numérique vu plus haut, la bande passante de ces filtres sera par exemple de 2,56 kHz c'est-à-dire la même que la bande passante du filtre 201. On obtient ainsi des composantes $X_3$ et $Y_3$.

Pour corriger en fréquence cette première approximation, on multiplie le signal complexe correspondant, dont $X_3$ et $Y_3$ représentent les composantes, par le signal complexe représentant l'écart de fréquence obtenu en sortie du multiplicateur 207 et dont $X_2$ et $Y_2$ représentent eux aussi les composantes. Cette opération s'effectue dans un multiplicateur 213 et se représente par les formules :

$$X_4 = X_2 X_3 - Y_2 Y_3 \qquad (4)$$

$$Y_4 = X_2 Y_3 + Y_2 X_3 \qquad (5)$$

En fait les signaux dipôlaires représentés par $X_4$ et $Y_4$ sont bien corrigés en fréquence pour correspondre à la démodulation selon la sous-porteuse à 2Fp, mais ils sont affectés d'erreurs de phase de provenances diverses.

Certaines erreurs de phase sont introduites par le système, par exemple par les erreurs résiduelles dans les filtres ou dans les multiplicateurs et on pourrait concevoir de les corriger par étalonnage.

Une erreur de phase importante par contre correspond à la différence de phase entre la sous-porteuse à 2Fp et la fréquence de démodulation à 2F0. Celle-ci est par principe aléatoire et il faut trouver un moyen pour la corriger.

Pour cela on procède à un filtrage à très faible bande passante (maximum 1 Hz) des composantes $X_4$ et $Y_4$, respectivement dans deux filtres identiques 214 et 215 qui délivrent des signaux de sortie $X_5$ et $Y_5$. Ces filtres permettent d'isoler la composante quasi continue du signal provenant de la démodulation des signaux dipolaires qui représentent en fait la sous-porteuse à 2Fp ramenée à une fréquence nulle dans l'espace des phases. En choisissant alors pour les filtres 214 et 215 des filtres ayant une erreur de phase nulle à cette fréquence 0, on obtient alors un signal complexe qui représente l'écart de phase entre la sous-porteuse à 2Fp et la fréquence à 2F0. Les composantes de ce signal complexe sont $X_5$ et $Y_5$. Ce qui rend possible, et même relativement facile, d'obtenir des filtres ayant une telle caractéristique est le fait que l'écart de phase nulle doit être obtenu à la fréquence 0 et sur une bande passante très faible.

Pour pouvoir alors corriger en phase les signaux dipôlaires corrigés en fréquence obtenus en sortie du multiplicateur 213, on multiplie le signal complexe qui les représente par un signal de correction obtenu à partir du signal complexe représenté $X_5$ et $Y_5$. Ce deuxième signal de correction est élaboré dans un module de calcul 216 qui permet d'obtenir les signaux $X_6$ et $Y_6$ donnés par les formules :

$$X_6 = Y_5/(X_5^{\,2} + Y_5^{\,2})^{\frac{1}{2}} \qquad (6)$$

$$Y_6 = - X_5/(X_5^{\,2} + Y_5^{\,2})^{\frac{1}{2}} \qquad (7)$$

A partir de ces signaux $X_6$ et $Y_6$, on corrige donc les signaux $X_4$ et $Y_4$ dans un module de multiplication complexe 217 qui délivre les signaux dipôlaires entièrement corrigés $X_7$ et $Y_7$ donnés par les formules :

$$X_7 = X_4 X_6 - Y_4 Y_6 \qquad (8)$$

$$Y_7 = X_4 Y_6 + Y_4 X_6 \qquad (9)$$

Ainsi qu'on l'a déjà signalé, tous ces traitements se font en numérique dans un système informatique, par exemple à base d'un microprocesseur convenablement programmé. Les calculs se font donc sur des échantillons numérisés e (t) qui arrivent à l'entrée du dispositif, et les signaux de sortie, aussi bien omni que dipôlaires, sont donc eux-mêmes échantillonnés. La fréquence d'échantillonnage sera bien sûr choisie pour répondre au critère de Nyquist. Comme les signaux sont des signaux à relativement basse fréquence elle pourra en fait être nettement supérieure, ce qui permettra d'obtenir plus facilement les caractéristiques des différents filtres utilisés, qui sont bien entendu des filtres numériques inclus dans la programmation. Compte tenu des dispositifs d'exploitation utilisés après et recevant les signaux de démodulation, il est intéressant, à titre de variante de l'invention, d'utiliser une fréquence d'échantillonnage adaptée à ces dispositifs, par exemple un analyseur de spectre.

Ainsi dans un exemple particulier de réalisation, on utilisera une fréquence d'échantillonnage Fs égale à $2^{16}/10$ Hz, soit 6553,6 Hz.

Dans ces conditions, pour éviter les intermodulations et la prise en compte de signaux parasites, il sera intéressant de choisir une fréquence F0 égale à une fréquence rationnelle de Fs, soit par exemple F0 = 8 Fs/7. 2F0 sera alors égale à 16 Fs/7, mais par contre on pourra utiliser pour les calculs de correction de phase au niveau des filtres 214 et 215 une fréquence d'échantillonnage beaucoup plus basse, puisque ces signaux évoluent très lentement dans le temps. Cette fréquence sera par exemple égale à Fs/64.

Une autre variante consisterait à introduire au niveau de la correction de phase dans le multiplicateur 217 un terme de correction élaboré dans les moyens de traitement des signaux, pour pouvoir par exemple obtenir une caractéristique particulière des signaux dipôlaires, par exemple une remise en phase du signal omni de manière à faire différents traitements tels que par exemple l'élaboration d'une cardioïde.

**Revendications**

1. Procédé de démodulation numérique d'un signal composite comprenant un premier signal omnidirectionnel en bande de base (101), une première sous-porteuse à une première fréquence Fp (102), une deuxième sous-porteuse à une fréquence 2Fp exactement égale au double de la fréquence Fp (103), un premier signal dipôlaire modulant en double bande latérale avec suppression de porteuse (104) la deuxième sous-porteuse et un deuxième signal dipôlaire modulant en double bande latérale avec suppression de porteuse en quadrature avec le premier signal (105) la deuxième sous-porteuse, caractérisé en ce qu'on effectue les étapes suivantes :

   - filtrage passe-bas (201) pour isoler le signal omnidirectionnel ;
   - démodulation complexe (202) par une fréquence F0 très stable peu différente de Fp pour obtenir un premier signal de différence de fréquence entre F0 et Fp;
   - élévation complexe au carré (207) puis normalisation du signal conjugué de ce premier signal d'erreur pour obtenir un premier signal de correction de fréquence ;
   - démodulation complexe (208) autour d'une deuxième fréquence à la fréquence 2F0 exactement égale à deux fois la fréquence F0 pour obtenir une première approximation des deux signaux dipôlaires ;
   - multiplication complexe (213) de cette première approximation de signaux dipôlaires par le premier signal de correction de fréquence pour obtenir des signaux dipôlaires corrigés en fréquence ;
   - filtrage passe-bas à très faible bande (214, 215) de ces signaux dipôlaires corrigés en fréquence pour isoler la composante continue correspondant à la deuxième sous-porteuse ramenée à la fréquence 0 ;
   - élaboration d'un signal de correction de phase (216) à partir de cette composante à la fréquence 0 ;
   - multiplication complexe (217) des signaux dipôlaires corrigés en fréquence par ce signal d'erreur de phase pour obtenir les signaux dipôlaires corrigés en fréquence et en phase.

2. Procédé selon la revendication 1, caractérisé en ce que la démodulation complexe autour de la fréquence 2F0 (218) comprend un filtrage (211, 212) qui est fait sur la même largeur de bande que le filtrage passe-bas (201) permettant de délivrer le signal omnidirectionnel.

3. Procédé selon l'une quelconque des revendications 1 et 2, caractérisé en ce que le filtrage passe-bas (214, 215) à très faible largeur de bande des signaux dipôlaires corrigés en fréquence présente une fréquence de coupure sensiblement égale à 1 Hz.

4. Procédé selon l'une quelconque des revendications 1 à 3, caractérisé en ce que l'on introduit dans le multiplicateur complexe (217) permettant d'obtenir la correction en phase des signaux dipôlaires une correction complémentaire permettant d'introduire une variation de phase volontaire des signaux dipôlaires destinée à faciliter le traitement ultérieur de ceux-ci.

5. Procédé selon la revendication 4, caractérisé en ce que cette modification volontaire des signaux dipôlaires consiste à les remettre en phase avec le signal omnidirectionnel obtenu dans le filtrage en bande de base (201).

**Patentansprüche**

1. Verfahren zur digitalen Demodulation eines mehrfach modulierten Signals, das ein erstes ungerichtetes Signal im Basisband (101), einen ersten Unterträger bei einer ersten Frequenz Fp (102), einen zweiten Unterträger (103) bei einer Frequenz 2Fp genau gleich dem Doppelten der Frequenz Fp, ein erstes bipolares Signal (104), das den zweiten Unterträger in Form einer Zweiseitenbandmodulation mit Trägerunterdrükkung moduliert, und ein zweites bipolares Signal (105) enthält, das den zweiten in Phasenquadratur liegenden Unterträger in Form einer Zweiseitenbandmodulation mit Trägerunterdrückung moduliert, dadurch gekennzeichnet, daß folgende Schritte durchgeführt werden:

   - das ungerichtete Signal wird in einem Tiefpaßfilter (201) isoliert;
   - man führt eine komplexe Demodulation (202) mit einer Frequenz F0 durch, die sehr stabil ist und sich von Fp wenig unterscheidet, so daß sich ein erstes für den Frequenzabstand zwischen F0 und Fp repräsentatives Signal ergibt;
   - das konjugierte Signal dieses ersten Fehlersignals wird quadriert (207) und dann normiert, so daß sich ein erstes Frequenzkorrektursignal ergibt;
   - man führt eine komplexe Demodulation (208) mit einer zweiten Frequenz 2F0 durch, die genau den doppelten Wert der Frequenz F0 besitzt, und erhält in erster Näherung die beiden bipolaren Signale;
   - man führt eine komplexe Multiplikation (213) dieses ersten Näherungswerts der bipolaren Signale mit dem ersten Frequenzkorrektursignal durch und erhält frequenzmäßig korrigierte bipolare Signale;
   - man filtert diese in der Frequenz korrigierten bipolaren Signale in einem sehr schmalbandigen Tiefpaßfilter (214, 215), um die Gleichstromkomponente entsprechend dem zweiten auf die Frequenz 0 gebrachten Unterträger zu isolieren;
   - man bildet ein Phasenkorrektursignal (216) ausgehend von dieser Komponente bei der Frequenz 0;
   - man führt eine komplexe Multiplikation (217) der frequenzmäßig korrigierten bipolaren Signale mit diesem Phasenkorrektursignal durch und erhält die frequenz- und phasenmäßig korrigierten bipolaren Signale.

2. Verfahren nach Anspruch 1, dadurch gekennzeichnet, daß die komplexe Demodulation bei der Frequenz 2F0 (218) eine Filterung (211, 212) enthält, die mit derselben Bandbreite wie die Tiefpaßfilterung (201) erfolgt, mit der das ungerichtete Signal erhalten wird.

3. Verfahren nach einem beliebigen der Ansprüche 1 und 2, dadurch gekennzeichnet, daß die sehr schmalbandige Tiefpaßfilterung (214, 215) der frequenzmäßig korrigierten bipolaren Signale mit einer Grenzfrequenz von im wesentlichen 1 Hz erfolgt.

4. Verfahren nach einem beliebigen der Ansprüche 1 bis 3, dadurch gekennzeichnet, daß bei der komplexen Multiplikation (217), bei der sich die Phasenkorrektur der bipolaren Signale ergibt, eine zusätzliche Korrektur erfolgt, bei der eine gezielte Phasenveränderung der bipolaren Signale durchgeführt wird, die die spätere Verarbeitung dieser Signale erleichtern soll.

5. Verfahren nach Anspruch 4, dadurch gekennzeichnet, daß diese gezielte Veränderung der bipolaren Signale darin besteht, sie mit dem ungerichteten Signal in Phase zu bringen, das bei der Filterung im Basisband (201) erhalten wird.

**Claims**

1. Method of digital demodulation of a composite signal comprising a first omnidirectional baseband signal (101), a first subcarrier at a first frequency Fp (102), a second subcarrier at a frequency 2Fp exactly equal to double the frequency Fp (103), a first dipolar signal modulating the second subcarrier in double sideband mode with carrier suppression (104), and a second dipolar signal modulating the second subcarrier in double sideband mode with carrier suppression in quadrature with the first signal (105), characterized in that the following steps are performed:

   - low-pass filtering (201) in order to isolate the omnidirectional signal;
   - complex demodulation (202) by a very stable frequency F0 hardly different from Fp in order to obtain a first signal of frequency difference between F0 and Fp;
   - complex squaring (207) then normalization of the conjugate signal of this first error signal in order to obtain a first frequency-correction signal;
   - complex demodulation (208) around a second frequency at the frequency 2F0 exactly equal to twice the frequency F0 in order to obtain a first approximation to the two dipolar signals;
   - complex multiplication (213) of this first approximation of dipolar signals by the first frequency-correction signal in order to obtain frequency-corrected dipolar signals;
   - very narrow-band, low-pass filtering (214, 215) of these frequency-corrected dipolar signals in order to isolate the DC component corresponding to the second subcarrier brought back to the frequency 0;
   - derivation of a phase-correction signal (216) from this component at the frequency 0;
   - complex multiplication (217) of the dipolar signals frequency corrected by this phase-error signal in order to obtain the frequency- and phase-corrected dipolar signals.

2. Method according to Claim 1, characterized in that the complex demodulation around the frequency 2F0 (218) comprises a filtering (211, 212) which is done over the same bandwidth as the low-pass filtering (201) making it possible to deliver the omnidirectional signal.

3. Method according to either of Claims 1 and 2, characterized in that the very narrow-bandwidth, low-pass filtering (214, 215) of the frequency-corrected dipolar signals exhibits a cutoff frequency substantially equal to 1 Hz.

4. Method according to any one of Claims 1 to 3, characterized in that a complementary correction is introduced into the complex multiplier (217) which makes it possible to obtain the phase correction of the dipolar signals, this complementary correction making it possible to introduce a deliberate phase variation of the dipolar signals intended to facilitate the subsequent processing of the latter.

5. Method according to Claim 4, characterized in that this deliberate modification of the dipolar signals consists in putting them back in phase with the omnidirectional signal obtained in the baseband filtering (201).

FIG.1

FIG. 2